# EUROPEAN PATENT APPLICATION

(11) **EP 4 557 894 A1**
(43) Date of publication of application: **21.05.2025**
(21) Application number: 22955078.5
(22) Date of filing: 10.08.2022
(51) Int. Cl.: H05K 1/11, H05K 3/42, H05K 3/00

(54) **PRINTED CIRCUIT BOARD AND MANUFACTURING METHOD THEREOF**

(71) Applicant: LG Electronics Inc., Yeongdeungpo-gu Seoul 07336 (KR)
(72) Inventor: KIM, Doekyong, Seoul 06772 (KR)
(74) Representative: Vossius & Partner Patentanwälte Rechtsanwälte mbB
(86) International application number: PCT/KR2022/011906
(87) International publication number: WO 2024/034703

(57) **Abstract**

The present invention relates to a printed circuit board and a manufacturing method thereof. A printed circuit board according to the present invention comprises: a substrate having a first layer to an n-th layer stacked in layers; a via hole formed through the first layer or the n-th layer along a stacking direction; a plating layer formed on the inside and the outside of the via hole; and a pad formed to separate the plating layer formed at the end of the via hole from the surrounding area. Accordingly, a via is formed at one side of the pad along the stacking direction to enable components density to be improved, thereby enabling the size of the substrate to be reduced.

## Description

### Technical field

The present disclosure relates to a printed circuit board and a method for manufacturing the same.

### Background Art

As noted, printed circuit boards or PCBs have a structure in which conductors and insulators are laminated, and various components, such as semiconductors, capacitors, and resistors are mounted on the PCBs.

Such a PCB is also called a single-sided, double-sided, 4-layer, 6-layer, or n*2-layer PCB, depending on the number of layers of circuits.

Typically, main boards of computers use 6-layer PCBs, graphics cards and the like use 8- or 10-layer PCBs, and network equipment uses PCBs with dozens of layers.

In a PCB, a substrate excluding conductors (circuits) is formed with an insulator, and is typically formed by laminating (stacking) a plurality of layers of glass fiber and epoxy plastic impregnated resin (PREPREG, PP).

In some embodiments, a through-via is provided to electrically connect different layers of circuits (layers) which are laminated with an insulator 110I between the layers.

The through-via includes a via hole formed through the different layers spaced apart (layered) with the insulator therebetween, and a plating layer formed by plating a conductor on an inner surface and opposite end surfaces of the via hole.

Accordingly, the circuit layers on the opposite sides of the insulator are electrically connected.

However, in the related art PCB and a manufacturing method thereof, when the through-via is formed below a component pad, an insulating material (PSR) is applied to lower and upper surfaces of the laminated substrate, and a PCB washing process is carried out. Afterwards, a washing solution (acidic solution) remains inside the via hole, which causes a problem with cracks of the PCB due to corrosion.

When the through-via is formed on the lower side of the component pad, the opposite side of the pad (e.g., a lower surface) is coated with the insulating material (PSR), and air inside the via hole expands at high temperature (for example, 245°C) during surface mounting (SMT), thereby causing a problem with a cold solder defect.

In case of forming the through-via on the lower side of the component pad, when the opposite side of the pad (e.g. the lower surface) is open, there is a problem in that solder may leak through the lower side of the via hole at high temperature during surface mounting (SMT).

Considering these problems, in the related art PCB and the manufacturing method thereof, the through-via is formed on one side spaced apart from the lower side of the component pad along a plate-surface direction.

However, in the related art PCB and the manufacturing method thereof, in which the through-via is formed at a point spaced apart from the lower side of the component pad in the plate-surface direction, the respective through-vias must be formed at points spaced apart from the component pad along the plate-surface direction. This causes a problem with deteriorating component density per unit area of the PCB.

Accordingly, the size of the PCB increases.

As the through-via is formed at the point spaced apart from the component pad in the plate-surface direction, a signal input to the component pad must be transmitted to the through-via spaced apart in the plate-surface direction. This causes a problem with increasing a transmission path (length) of the signal.

As a result, signal processing speed decreases as the signal transmission path (length) increases, which limits the improvement of product performance.

Considering these problems, in some PCBs and manufacturing methods thereof, a method of forming a laser-via in the lower side of the component pad using a laser is used.

However, in the related art PCBs having the laser-via and the manufacturing methods thereof, expansive laser equipment is required, which causes a problem with a significant increase in manufacturing costs when manufacturing the PCBs.

### Disclosure of Invention

### Technical Problem

Therefore, an aspect of the disclosure is to provide a printed circuit board (PCB) capable of reducing a size of a substrate by forming a via in one side of a pad in a laminating direction, and a manufacturing method thereof.

Another aspect of the disclosure is to provide a PCB capable of shortening a signal transmission path and improving signal processing speed, and a manufacturing method thereof.

Still another of the disclosure is to provide a PCB capable of increasing component density at low cost, and a manufacturing method thereof.

### Solution to Problem

A printed circuit board according to the present disclosure for solving the aforementioned problems is characterized in that a via is formed on one side of a pad along a laminating direction.

In some embodiments, a via hole may be formed through a first layer arranged on a lowermost side and an n-th layer arranged on an uppermost of a substrate having a plurality of layers laminated in layers, a plating layer made of a conductor may be formed inside and outside the via hole, and a pad may be formed by separating a plating layer, exposed to outside, the plating layer from a peripheral area, thereby reducing the size of the printed circuit board.

A signal input from the pad may be transmitted through the plating layer of the via hole, thereby shortening a signal transmission path.

Additionally, signal processing speed may be improved.

Here, the via hole may be formed by using a drill.

This may result in reducing manufacturing costs.

A printed circuit board according to an embodiment may include: a substrate including a first layer to an n-th layer laminated in layers; a via hole formed in a penetrating manner, including the first layer or the n-th layer, in a laminating direction; a plating layer formed inside and outside the via hole; and a pad formed by separating a plating layer formed on an end of the via hole from a peripheral area.

In this way, components density may be increased by arranging a via on one side of the pad along the laminating direction.

This may result in reducing the size of the printed circuit board.

Additionally, the signal transmission path between the pad and the via may be shortened, and signal processing speed may increase.

In an embodiment, the via hole may include an n_n-1-th via hole formed through the n-th layer and an n-1-th layer,

The plating layer may include an n_n-1-th inner plating layer formed on an inner surface of the n_n-1-th via hole; and n_n-1-th end plating layers formed on opposite ends of the n_n-1-th via hole, respectively,

The pad may be formed on the n_n-1-th end plating layers, exposed to outside, of the n_n-1-th end plating layers of the n_n-1-th via hole.

Here, an n_n-1-th filling part may be formed by filling an inside formed by the n_n-1-th inner plating layer and the n_n-1-th end plating layers of the n_n-1-th via hole with an insulating material.

Accordingly, air inside the n_n-1-th via hole may be reduced (removed), thereby suppressing an occurrence of a cold solder defect in solder due to air expansion during surface mounting.

The n_n-1-th via hole may be blocked during surface mounting, thereby suppressing solder leakage through the n_n-1-th via hole.

In an embodiment, the via hole may include a 2_1-th via hole formed through the second layer and the first layer,

The plating layer may include a 2_1-th inner plating layer formed on an inner surface of the 2_1-th via hole, and 2_1-th end plating layer formed on opposite ends of the 2_1-th via hole, respectively,

The pad may be formed on the 2_1-th end plating layers, exposed to outside, of the 2_1-th end plating layers of the 2_1-th via hole.

Here, the printed circuit board may further include a 2_1-th filling part formed by filling an inside formed by the 2_1-th inner plating layer and the 2_1-th end plating layers of the 2_1-th via hole with an insulating material.

Accordingly, an air layer inside the 2_1-th via hole may be reduced (removed), thereby suppressing an occurrence of a cold solder defect in solder due to air expansion during surface mounting.

The 2_1-th via hole may be blocked during surface mounting, thereby suppressing solder leakage through the 2_1-th via hole.

In an embodiment, the via hole may include a 2_1-th via hole formed through the second layer and the first layer, and an n_n-1-th via hole formed through the n-th layer and an n-1-th layer,

The plating layer may include: a 2_1-th inner plating layer formed on an inner surface of the 2_1-th via hole; 2_1-th end plating layers formed on opposite ends of the 2_1-th via hole, respectively; an n_n-1 inner plating layer formed on an inner surface of the n_n-1-th via hole; and n_n-1-th end plating layers formed on opposite ends of the n_n-1-th via hole, respectively,

The pad may be formed on the 2_1-th end plating layers, exposed to outside, of the 2_1-th end plating layers of the 2_1-th via hole, and the n_n-1-th end plating layers, exposed to outside, of the n_n-1-th end plating layers of the n_n-1-th via hole.

Here, the printed circuit board may further include a 2_1-th filling part formed by filling an inside formed by the 2_1-th inner plating layer and the 2_1-th end plating layers of the 2_1-th via hole with an insulating material; and

An n_n-1-th filling part may be formed by filling an inside formed by the n_n-1-th inner plating layer and the n_n-1-th end plating layers of the n_n-1-th via hole with an insulating material.

Accordingly, air layers inside the 2_1-th via hole and the n_n-1-th via hole may be reduced (removed), thereby suppressing an occurrence of a cold solder defect in solder due to air expansion during surface mounting.

Additionally, the 2_1-th via hole and the n_n-1-th via hole may each be blocked during surface mounting, thereby suppressing solder leakage through the 2_1-th via hole and the n_n-1-th via hole.

In an embodiment, the via hole may include a through-via hole formed through the first layer to the n-th layer,

The plating layer may include an inner plating layer formed on an inner surface of the through-via hole and end plating layers formed on opposite ends of the through-via hole, respectively,

The pad may be formed on the end plating layers formed on the respective opposite ends of the through-via hole.

Here, the printed circuit board may further include a filling part formed by filling an inside formed by the inner plating layer and the end plating layers of the through-via hole with an insulating material.

Accordingly, an air layer inside the through-via hole may be reduced (removed), thereby suppressing an occurrence of a cold solder defect in solder due to air expansion in the through-via hole during surface mounting.

The through-via hole may be blocked during surface mounting, thereby suppressing solder leakage through the through-via hole.

In an embodiment, insulators formed in a shape of plate may be arranged between adjacent layers of the first layer to the n-th layer, and the via hole may be formed by a drill.

Accordingly, the use of expensive laser equipment may be eliminated, thereby suppressing cost increases in the manufacture of the via hole.

In an embodiment, the via hole may further include an intermediate via hole formed through at least two continuous layers of the second layer to the n-1-th layer,

The plating layer may include an inner plating layer formed on an inner surface of the intermediate via hole and end plating layers formed on opposite ends of the intermediate via hole, respectively.

Here, the printed circuit board may further include a filling part formed by filling an inside formed by the inner plating layer and the end plating layers of the intermediate via hole with an insulating material.

Accordingly, air inside the intermediate via hole may be reduced (removed), thereby suppressing an occurrence of a cold solder defect due to air expansion in the intermediate via hole during surface mounting.

According to another aspect of the disclosure, a method for manufacturing a printed circuit board may include: forming a plurality of layers arranged in layers with insulators therebetween;
forming a via hole in a penetrating manner, including an n-th layer arranged on an uppermost side or a first layer arranged on a lowermost side in a laminating direction;
forming a plating layer inside and outside the via hole; and
forming a pad by separating a plating layer, exposed to outside, of the plating layer of the via hole from a peripheral area.

With the configuration, components density of the printed circuit board may be increased, and the size of the printed circuit board may be reduced.

Additionally, a signal transmission path may be shortened and signal processing speed may increase.

In an embodiment, the forming the plating layer may include:
forming an inner plating layer on an inner surface of the via hole; and
forming end plating layers formed on opposite ends of the via hole, respectively.

In an embodiment, the method for manufacturing the printed circuit board may further include, before forming the end plating layers,
forming a filling part by filling an inside of the inner plating layer with an insulating material.

With the configuration, air inside the via hole may be reduced (excluded), thereby suppressing an occurrence of defects due to air expansion inside the via hole during surface mounting.

In an embodiment, the method for manufacturing the printed circuit board may further include, prior to forming the via hole,
preparing a drill to drill through the plurality of layers.

This may eliminate the use of expensive equipment such as a laser, thereby suppressing an increase in manufacturing cost due to the via hole formation.

In an embodiment, the forming the via hole may include forming a 2_1-th via hole formed through a second layer and the first layer.

In an embodiment, the forming the via hole may include:
forming an n_n-1-th via hole through the n-th layer and an n-1-th layer.

In an embodiment, the method for manufacturing the printed circuit board may further include, prior to forming the pad,
laminating the plurality of layers in layers; and
insulating surfaces of the plurality of layers laminated in layers.

According to still another aspect of the disclosure, a method for manufacturing a printed circuit board may include: forming a plurality of layers arranged in layers with insulators therebetween;
laminating the plurality of layers such that a first layer is arranged on a lowermost side and an n-th layer is arranged on an uppermost side in a laminating direction;
forming a via hole including a through-via hole formed through the n-th layer to the first layer;
forming a plating layer inside and outside the via hole including the through-via hole; and
forming a pad by separating a plating layer, exposed to outside, of the plating layer of the through-via hole from a peripheral area.

With the configuration, components density of the printed circuit board may be increased, and the size of the printed circuit board may be reduced.

Additionally, a signal transmission path may be shortened and signal processing speed may increase.

In an embodiment, the forming the plating layer inside and outside the via hole including the through-via hole may include: forming an inner plating layer on an inner surface of the through-via hole; and forming end plating layers on opposite ends of the through-via hole.

Here, the method for manufacturing the printed circuit board may further include, prior to forming the end plating layers of the through-via hole, forming a filling part by filling an inside of the inner plating layer of the through-via hole with an insulating material.

The forming the via hole including the through-via hole may further include
forming an intermediate via hole through at least two continuous layers of the first layer to the n-th layer, not to be exposed to the outside.

The forming the plating layer inside and outside the via hole including the through-via hole may include; forming an inner plating layer on an inner surface of the through-via hole; and forming end plating layers on opposite ends of the through-via hole.

The method for manufacturing the printed circuit board may further include, prior to forming the end plating layers of the intermediate via hole, forming a filling part by filling an inside of the inner plating layer of the intermediate via hole with an insulating material.

### Advantageous Effects of Invention

As described above, according to an embodiment of the disclosure, components density may be improved and the size of a substrate may be reduced by providing a via hole formed in a penetrating manner, including a first layer or an n-th layer, along a laminating direction, a plating layer formed inside and outside of the via hole, and a pad formed to separate the plating layer formed on an end of the via hole from a peripheral surrounding area. Signal transmission paths may also be shortened, which may increase signal processing speed.

An n_n-1-th filling part may be formed by filling the interior of an n_n-1-th via hole penetrating an n-th layer and an n-1-th layer with an insulating material, thereby reducing air inside the n_n-1-th via hole. This may suppress the occurrence of defects (a cold solder defect) due to air expansion inside the n_n-1-th via hole. Also, solder leakage through the n_n-1-th via hole may be suppressed.

A 2_1-th filling part may be formed by filling a 2_1-th via hole penetrating a second layer and a first layer with an insulating material, such that air inside the 2_1-th via hole may be reduced, thereby suppressing the occurrence of a cold solder defect due to air expansion.

An n_n-1-th filling part and a 2_1-th filling part may be formed respectively by filling the n_n-1-th via hole and the 2_1-th via hole with an insulating material, air inside each via hole may be reduced (removed). Accordingly, the occurrence of a cold solder defect caused by air expansion inside each via hole due to high temperature during surface mounting may be suppressed.

Each via hole may be formed by a drill, thereby eliminating the use of expensive laser equipment. This may suppress an increase in manufacturing cost due to the formation of the via hole.

### Brief Description of Drawings

FIG. 1 is a cross-sectional view of a main part of a printed circuit board (PCB) according to an embodiment.
FIG. 2 is a view for explaining a method of manufacturing a PCB according to an embodiment.
FIGS. 3A to 3I are views for explaining a manufacturing process of the PCB of FIG. 1.
FIG. 4 is a cross-sectional view of a main part of a printed circuit board (PCB) according to another embodiment.
FIGS. 5A to 5I are views for explaining a manufacturing process of the PCB of FIG. 4.
FIG. 6 is a cross-sectional view of a main part of a printed circuit board (PCB) according to still another embodiment.
FIG. 7 is a view for explaining a method of manufacturing a PCB according to another embodiment.
FIGS. 8A to 8H are views for explaining a manufacturing process of the PCB of FIG. 6.

### Mode for the Invention

Hereinafter, embodiments disclosed in this specification will be described in detail with reference to the accompanying drawings. In this specification, the same or equivalent components may be provided with the same or similar reference numbers even in different embodiments, and description thereof will not be repeated. A singular representation as used herein may include a plural representation unless it represents a definitely different meaning from the context. In describing the present invention, if a detailed explanation for a related known technology or construction is considered to unnecessarily divert the gist of the present disclosure, such explanation has been omitted but would be understood by those skilled in the art. It should be noted that the attached drawings are provided to facilitate understanding of the embodiments disclosed in this specification, and should not be construed as limiting the technical idea disclosed in this specification by the attached drawings.

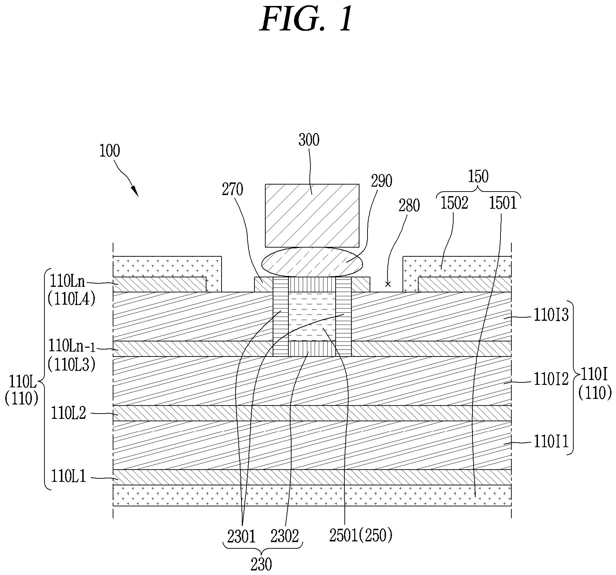

FIG. 1 is a cross-sectional view of a main part of a printed circuit board (PCB) according to an embodiment. As illustrated in FIG. 1, a PCB 100 according to an embodiment may include a substrate 110, a via hole 210, a plating layer 230a, and a pad 270.

The substrate 110 may include a plurality of layers 110L that are laminated (stacked) in layers.

In the embodiment, a laminating direction of the plurality of layers 110L may indicate an up-and-down (or vertical) direction in the drawing.

In this embodiment, the plurality of layers 110L may be configured as circuit layers made of, for example, a conductor (for example, copper (Cu)).

The plurality of layers 110L may include a first layer 110L1 to an n-th layer 110Ln along the laminating direction.

The plurality of layers 110L may be spaced apart from each other along the laminating direction.

A plate-shaped insulator 110I may be provided between the plurality of layers 110L.

Accordingly, the plurality of layers 110L (circuit layers 110L) may be insulated from each other.

The plurality of layers 110L may be implemented as a first layer 110L1 to a fourth layer 110L4.

The insulator 110I may be provided between adjacent layers of the first layer 110L1 to the fourth layer 110L4.

The insulator 110I may be formed in a plate shape using a composite material called prepreg, which is made by impregnating a liquid synthetic resin, such as epoxy resin, into a fiber reinforcing agent, such as glass fiber or carbon fiber.

In this embodiment, the plurality of layers 110L may be arranged on one surface or opposite surfaces of the plate-shaped insulator 110I.

In this embodiment, the plurality of layers 110L may be implemented as the first layer 110L1 to the fourth layer 110L4.

In this embodiment, the insulator 110I may include a first insulator 110I1 to a third insulator 110I3.

For example, the first layer 110L1 may be formed on a lower surface of the first insulator 110I1, and the second layer 110L2 may be formed on a lower surface of the second insulator 110I2. The third layer 110L3 may be formed on a lower surface of the third insulator 110I3, and the n-th layer 110Ln (the fourth layer 110L4) may be arranged on an upper surface of the third insulator 11013.

This embodiment illustrates an example in which the plurality of layers 110L include the first layer 110L1 to the fourth layer 110L4, but is merely illustrative, and may not be limited thereto. That is, the plurality of layers 110L may be implemented to have six layers, eight layers, or ten layers.

An insulating layer 150 may be formed on opposite surfaces (lower surface and upper surface) along the laminating direction of the substrate 110.

The insulating layer 150 may be formed by, for example, coating outer surface of plated (copper foil) circuit layers (in this embodiment, the first layer 110L1 and the fourth layer 110L4) with a permanent ink.

The insulating layer 150 may include, for example, a lower insulating layer 1501 coated on the outer surface of the first layer 110L1 and an upper insulating layer 1502 coated on the outer surface of the n-th layer 110Ln (the fourth layer 110L4).

The substrate 110 may include a via hole 210 formed through the substrate 110, including the n-th layer 110Ln as the uppermost layer (in this embodiment, the fourth layer 110L4).

In this embodiment, the via hole 210 may include an n_n-1-th via hole 2101 formed through the n-th layer 110Ln and an n-1-th layer 110Ln-1. In this embodiment, the uppermost n-th layer 110Ln may be the fourth layer 110L4, and thus the n_n-1-th via hole 2101 may be referred to as a 4_3-th via hole 2101.

In this embodiment, the via hole 210 may be formed in the penetrating manner using a drill 220.

In some embodiments, the via hole 210 (the n_n-1-th via hole 2101) may be formed through the n-th layer 110Ln, the third insulator 11013, and the n-1-th layer 110Ln-1 by the drill 220.

The via hole 210, for example, may have an inner diameter of 0.6 mm.

In this embodiment, the example in which the inner diameter of the via hole 210 is set to 0.6 mm is illustrated, but this is only an example and the size may be adjusted.

A plating layer 230 may be formed in the via hole 210 (the n_n-1-th via hole 2101).

In this embodiment, the plating layer 230 may include an n_n-1-th inner plating layer 2301 formed on an inner surface of the n_n-1-th via hole 2101, and n_n-1-th end plating layers 2302 formed on ends of the n_n-1-th via hole 2101.

Here, the plating layer 230 (i.e., the n_n-1-th inner plating layer 2301 and the n_n-1-th end plating layers 2302) may be implemented by, for example, copper (Cu) plating.

Accordingly, the n-th layer 110Ln (the fourth layer 110L4) and the n-1-th layer 110Ln-1 (the third layer 110L3) may be electrically connected. A signal transmission path may thus be formed between the n-th layer 110Ln and the n-1-th layer 110Ln-1.

The n_n-1-th via hole 2101, the n_n-1-th inner plating layer 2301, and the n_n-1-th end plating layers 2302 may be referred to as a via 200.

In this embodiment, the via 200 may include the n_n-1-th via hole 2101, the n_n-1-th inner plating layer 2301, and the n_n-1-th end plating layers 2302.

In this embodiment, the first layer 110L1 to the n-th layer 110Ln and the plating layer 230 are depicted differently (distinctively) for convenience of explanation in the drawing, but may actually be made of the same material (for example, copper (Cu)).

A filling part 250 may be formed by filling the inside of the plating layer 230 with an insulating material.

In some embodiments, an n_n-1-th filling part 2501 may be arranged inside the n_n-1-th via hole 2101.

Accordingly, air inside the n_n-1-th via hole 2101 may be reduced (removed).

According to this configuration, air expansion inside the n_n-1-th via hole 2101 due to high temperature during surface mounting may be suppressed.

This may result in suppressing an occurrence of a cold solder defect due to the air expansion of a solder 290 which is bonded to a pad 270 to be described later.

In this embodiment, a plating layer 230 (the n_n-1-th end plating layer 2302), which is exposed to the outside, of the plating layer 230 may include a pad 270 formed by being separated from a surrounding area.

The pad 270 may have a size larger than the via hole 210, for example.

In this embodiment, the pad 270 may be configured by including the n_n-1-th inner plating layer 2301, an end of the corresponding n_n-1-th end plating layer 2302, and a portion of the n-th layer 110Ln.

The pad 270 may be formed, for example, in a circular shape.

In this embodiment, the pad 270 implemented in the circular shape is illustrated, but this is merely illustrative, and may be implemented in a polygonal shape, such as a square, pentagon, hexagon, or octagon, or in an oval shape.

A component 300 may be coupled (mounted) to the pad 270 by a solder 290.

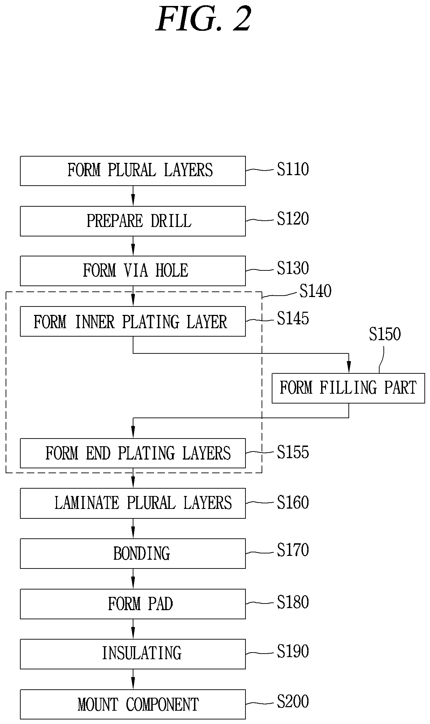

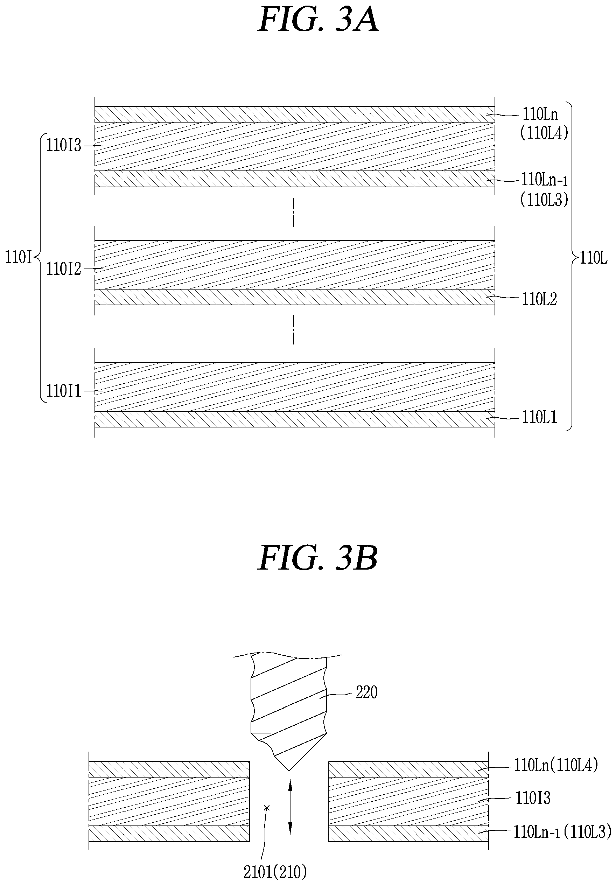

FIG. 2 is a view for explaining a method of manufacturing a PCB according to an embodiment, and FIGS. 3A to 3I are views for explaining a manufacturing process of the PCB of FIG. 1. As illustrated in FIG. 2, a method of manufacturing a PCB 100 according to an embodiment of the disclosure may include forming a plurality of layers 110L arranged in layers with an insulator 110I therebetween (S110), forming a via hole 210 in a penetrating manner, including an n-th layer 110Ln arranged on the uppermost side in a laminating direction or a first layer 110L1 arranged on the lowermost side (S130), forming a plating layer 230 inside and outside the via hole 210 (S140), and forming a pad 270 by separating a plating layer, exposed to outside, of the plating layer 230 of the via hole 210 from a peripheral area (surrounding area) (S180).

As illustrated in FIG. 3A, the plurality of layers 110L may include a first layer 110L1 to an n-th layer 110Ln which are spaced apart in the laminating direction. This embodiment illustrates an example in which the plurality of layers 110L include a first layer 110L1 to a fourth layer 110L4, but is merely illustrative, and may not be limited thereto.

The plurality of layers 110L may be circuit layers formed of copper (Cu).

The plurality of layers 110L may be arranged on one or opposite surfaces of the insulator 110I.

In this embodiment, the insulator 110I may include a first insulator 110I1 to a third insulator 110I3.

In some embodiments, the first layer 110L1 may be arranged on a lower surface of the first insulator 110I1.

The second layer 110L2 may be arranged on a lower surface of the second insulator 11012.

The third layer 110L3 may be arranged on a lower surface of the third insulator 110I3, and the fourth layer 110L4 may be arranged on an upper surface of the third insulator 11013.

The manufacturing method may further include, prior to forming the via hole 210 (S130), preparing a drill 220 (S120).

As illustrated in FIG. 3B, the via hole 210 (an n_n-1-th via hole 2101) may be formed in a penetrating manner by the drill 220.

In this embodiment, the via hole 210 may include an n_n-1-th via hole 2101 formed through an n-th layer 110Ln and an n-1-th layer 110Ln-1.

In some embodiments, the n_n-1-th via hole 2101 may be formed through the n-th layer 110Ln, the third insulator 110I3, and the n-1-th layer 110Ln-1. In this embodiment, the n-th layer 110Ln may be the fourth layer 110L4, and thus the n_n-1-th via hole 2101 may refer to a 4_3-th via hole 2101.

The step (S140) of forming the plating layer 230 inside and outside the via hole 210 may include forming an inner plating layer 230 on an inner surface of the via hole 210 (S145), and forming end plating layers 230 formed on opposite ends of the via hole 210, respectively (S155).

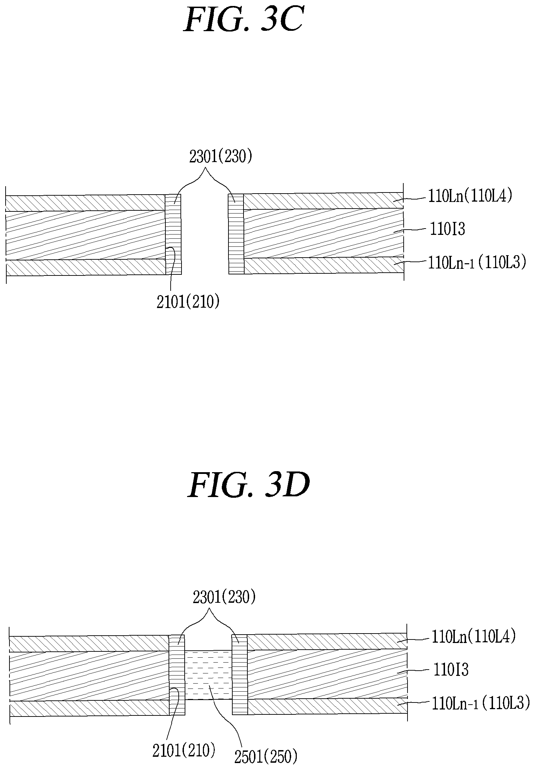

As illustrated in FIG. 3C, the inner plating layer 2301 (an n_n-1-th inner plating layer 2301) may be formed on the inner surface of the via hole 210 (the n_n-1-th via hole 2101) by copper (Cu) plating. The n_n-1-th inner plating layers 2301 formed in the n-th layer 110Ln, the third insulator 11013, and the n-1-th layer 110Ln-1.

The manufacturing method may further include, prior to forming the end plating layers 2302 (S145), forming a filling part 250 by filling an inside of the inner plating layer 2301 with an insulating material (resin) (S150).

As illustrated in FIG. 3D, the filling part 250 (an n_n-1-th filling part 2501) may be formed by filling the inside of the inner plating layer 2301 (the n_n-1-th inner plating layer 2301) with the insulating material (resin).

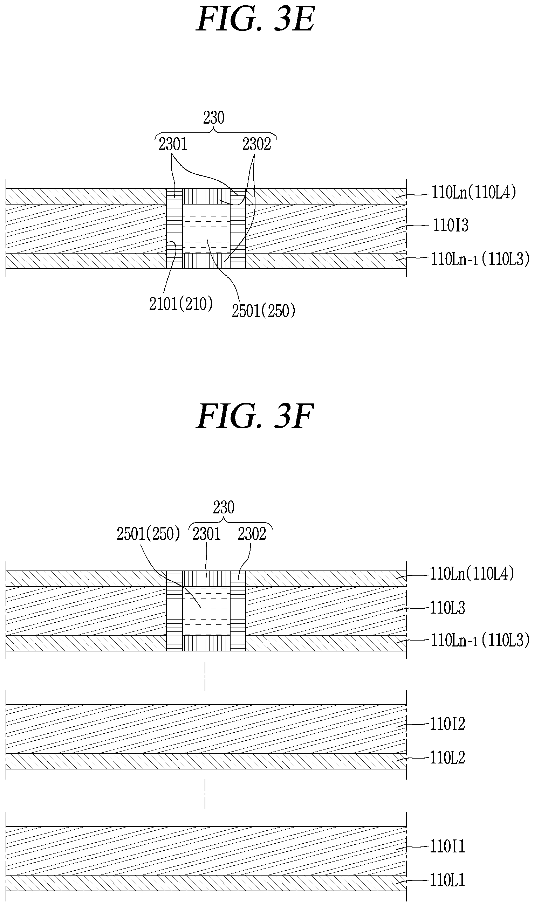

As illustrated in FIG. 3E, the end plating layers 2302 (n_n-1-th end plating layers 2302) may be formed on opposite ends of the via hole 210 (the n_n-1-th via hole 2101), respectively, in the laminating direction. Here, the end plating layers 2302 may be formed to be flush with the n-th layer 110Ln and the n-1-th layer 110Ln-1.

The manufacturing method may further include, after forming the end plating layers 2302 (S145), laminating the plurality of layers 110L (S160).

The plurality of layers 110L may be laminated, as illustrated in FIG. 3F, after the plating layer 230 is formed inside and outside the via hole 210 (S140).

The manufacturing method may further include, after laminating the plurality of layers 110L (S160), bonding the plurality of layers 110L (S170).

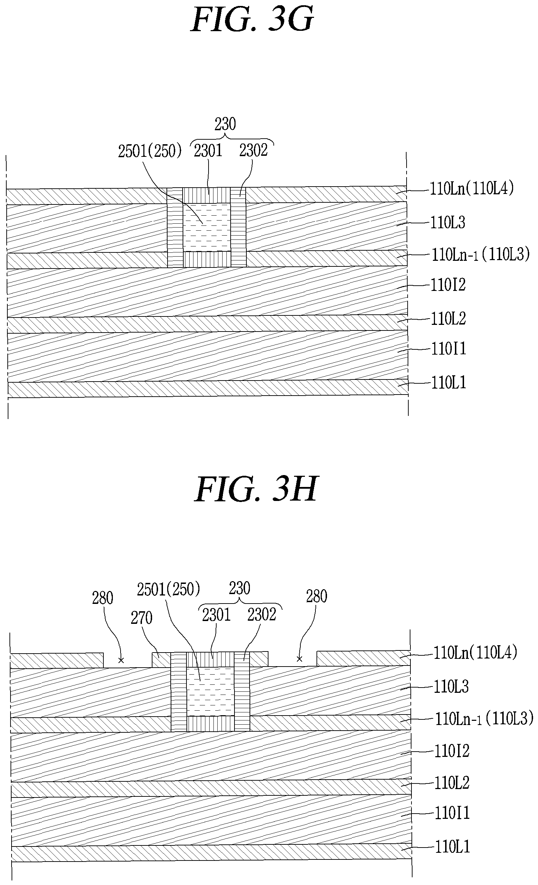

As illustrated in FIG. 3G, the plurality of laminated layers 110L may be bonded (thermally bonded, hot-pressed).

After bonding the plurality of layers 110L (S170), the pad 270 may be formed by separating the end plating layer 2302, which is exposed to the outside, of the end plating layer 2302 from the peripheral area.

As illustrated in FIG. 3H, the pad 270 may be formed by separating the n_n-1-th end plating layer 2302, which is exposed to the outside, of the n_n-1-th end plating layer 2302 from the peripheral area.

The pad 270 may be formed to have a diameter larger than, for example, a diameter of the via hole 210 (the n_n-1-th via hole 2101).

The pad 270 may be configured to include a portion of the n-th layer 110Ln.

The pad 270 may be formed in a circular shape, for example, and a cut portion 280 may be formed around the pad 270 by cutting out a portion of the n-th layer 110Ln such that the pad 270 is spaced apart from the n-th layer 110Ln.

The manufacturing method may further include, after forming the pad 270 (S180), insulating surfaces of the lowermost layer (the first layer 110L1) and the uppermost layer (the n-th layer 110Ln) of the plurality of layers 110L (S190).

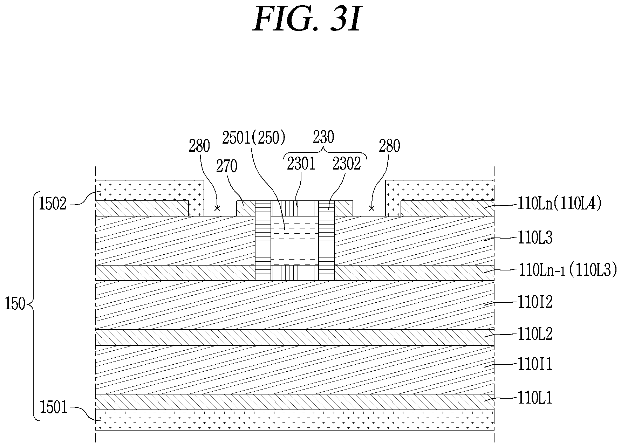

As illustrated in FIG. 3I, an insulating layer 150 may be formed on the outer surface (lower surface) of the first layer 110L1 and the outer surface (the upper surface) of the n-th layer 110Ln.

Here, the insulating layer 150 may be formed by, for example, coating the outer surfaces of the first layer 110L1 and the n-th layer 110Ln (the fourth layer 110L4) with a permanent ink.

The manufacturing method may further include, after insulating the plurality of layers 110L (S190), mounting a component 300 by interposing a solder 290 between the component 300 and the pad 270 (S200).

Referring back to FIG. 1, the component 300 may be mounted on the upper surface of the pad 270 by interposing the solder 290 between the pad 270 and the component 300.

With this configuration, a signal input from the component 300 may be transmitted to the third layer 110L3 via the solder 290, the pad 270, and the inner plating layer 230 (the n_n-1-th inner plating layer 2301).

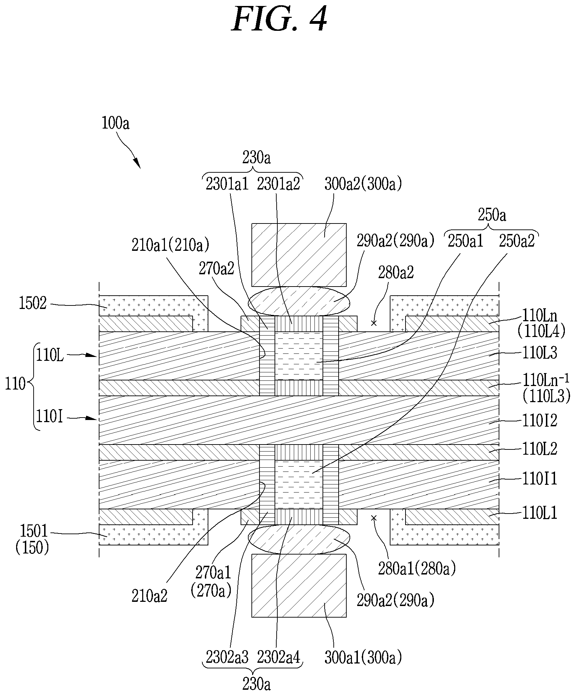

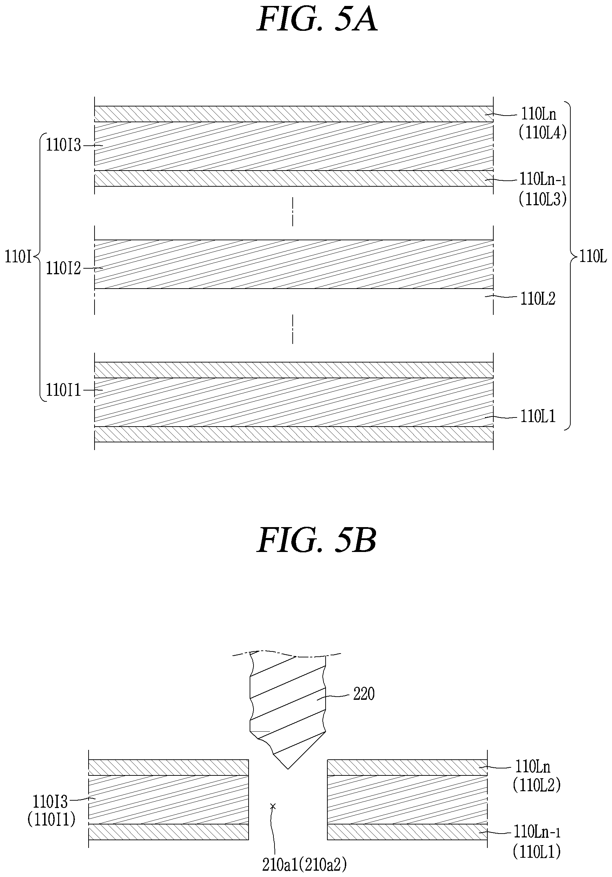

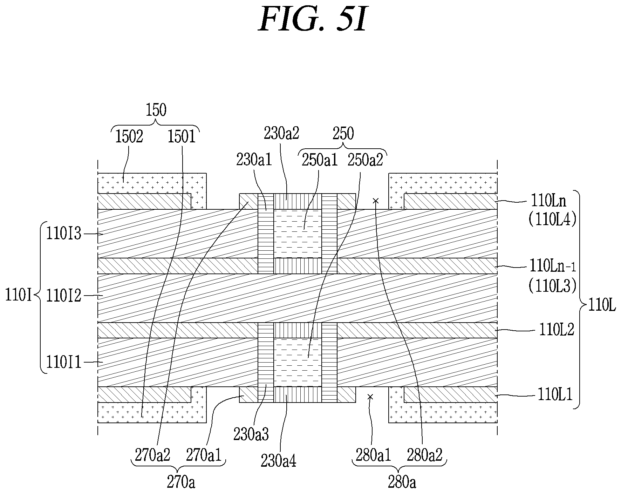

FIG. 4 is a cross-sectional view of a main part of a printed circuit board (PCB) according to another embodiment, and FIGS. 5A to 5I are views for explaining a manufacturing process of the PCB of FIG. 4.

As illustrated in FIG. 4, a PCB 100a according to another embodiment may include a substrate 110, a via hole 210a, a plating layer 230a, and a pad 270a.

The substrate 110 may include a plurality of layers 110L that are laminated in layers.

In this embodiment, each of the plurality of layers 110L may be a circuit layer formed of copper (Cu).

The plurality of layers 110L may include a first layer 110L1 to an n-th layer 110Ln that are laminated from the bottom along the laminating direction.

A plate-shaped insulator 110I (for example, prepreg) may be provided between the plurality of layers 110L.

Accordingly, the plurality of layers 110L may be insulated from each other by the insulator 110I. In this embodiment, the plurality of layers 110L may include a first layer 110L1 to a fourth layer 110L4.

This embodiment illustrates an example in which the plurality of layers 110L include the first layer 110L1 to the fourth layer 110L4, but is merely illustrative, and may not be limited thereto.

The plurality of layers 110L may be arranged on one or opposite surfaces of the insulator 110I.

The insulator 110I may include first to third insulators 110I1 spaced apart in layers.

In some embodiments, in this embodiment, the first layer 110L1 may be arranged on a lower surface of the first insulator 110I1, and the second layer 110L2 may be arranged on an upper surface of the first insulator 110I1.

The third layer 110L3 may be arranged on a lower surface of the third insulator 110I3, and the n-th layer 110Ln (the fourth layer 110L4) may be arranged on an upper surface of the third insulator 11013.

The second insulator 110I2 may be inserted between the second layer 110L2 and the third layer 110L3.

The second insulator 11012 may be arranged between the second layer 110L2 and the third layer 110L3.

Accordingly, the second layer 110L2 and the third layer 110L3 may be insulated from each other.

The via hole 210a may include, for example, an n_n-1-th via hole 210a1 formed through the n-th layer 110Ln and an n-1-th layer 110Ln-1.

The via hole 210a may include, for example, a 2_1-th via hole 210a2 formed through the second layer 110L2 and the first layer 110L1.

The via hole 210a, for example, may have a diameter of 0.6 mm.

The via hole 210a may be formed by a drill 220.

This may suppress an increase in manufacturing cost of the via hole 210a.

The plating layers 230a may each be formed by copper (Cu) plating.

The plating layer 230a may include, for example, an n_n-1-th inner plating layer 230a1 formed on an inner surface of the n_n-1-th via hole 210a1, and n_n-1-th end plating layers 230a2 formed on opposite ends of the n_n-1-th via hole 210a1.

Therefore, the n-th layer 110Ln and the n-1-th layer 110Ln-1 may be electrically connected to each other.

The plating layer 230a may include, for example, a 2_1-th inner plating layer 230a3 formed on an inner surface of the 2_1-th via hole 210a2, and 2_1-th end plating layers 230a4 formed on opposite ends of the 2_1-th via hole 210a2.

Accordingly, the first layer 110L1 and the second layer 110L2 may be electrically connected to each other.

Here, the n_n-1-th via hole 210a1, the n_n-1-th inner plating layer 230a1, and the n_n-1-th end plating layers 230a2 may be referred to as, for example, an upper via.

Also, the 2_1-th via hole 210a2, the 2_1-th inner plating layer 230a3, and the 2_1-th end plating layers 230a4 may be referred to as, for example, a lower via.

In this embodiment, the first layer 110L1 to the n-th layer 110Ln and each plating layer 230a are depicted as being distinct from one another for convenience of explanation in the drawings, but such layers are actually all formed of the same material (copper (Cu)).

In some embodiments, a filling part 250a may be formed by filling an inside of the plating layer 230a with an insulating material (e.g., resin).

In some embodiments, an n_n-1 filling part 250a1 may be formed in a space defined by the n_n-1-th inner plating layer 230a1 and the n_n-1-th end plating layers 230a2.

Accordingly, air inside the n_n-1-th via hole 210a1 may be reduced (removed), thereby suppressing the occurrence of a cold solder defect due to air expansion during surface mounting.

A 2_1-th filling part 250a2 filled with the insulating material (for example, the resin) may be formed in a space defined by the 2_1-th inner plating layer 230a3 and the 2_1-th end plating layers 230a4.

Accordingly, air inside the 2_1-th via hole 210a2 may be reduced, thereby suppressing the occurrence of a cold solder defect due to air expansion during surface mounting.

In this embodiment, a pad 270a may be formed by separating the plating layer 230a, which is exposed to the outside, of the plating layer 230a from the peripheral area (the circuit layers of the n-th layer 110Ln and the first layer 110L1). A cut portion 280a may be formed around the pad 270a to separate the pad 270a from the corresponding circuit layer.

In some embodiments, an upper pad 270a2 may be formed on the n_n-1-th end plating layer 230a2, which is exposed to the outside, of the n_n-1-th end plating layer 230a2. An upper cut portion 280a2 may be formed around the upper pad 270a2 by cutting off a portion of the n_n-1-th layer.

Also, a lower pad 270a1 may be formed on the 2_1-th end plating layer 230a4, which is exposed to the outside, of the 2_1-th end plating layer 230a4. A lower cut portion 280a1 may be formed around the lower pad 270a1 by cutting off a portion of the first layer 110L1.

Components 300a may mounted on the respective pads 270a (the upper pad 270a2 and the lower pad 270a1) by interposing solders 290a between the components 300a and the pads 270a.

In some embodiments, a lower component 300a1 may be mounted on the lower pad 270a1 by interposing a lower solder 290a1 between the lower component 300a1 and the lower pad 270a1, and an upper component 290a1 may be mounted on the upper pad 270a2 by interposing an upper solder 290a2 between the upper component 290a1 and the upper pad 270a2.

Hereinafter, a manufacturing process of the PCT 100a will be described with reference to FIGS. 5A to 5I.

As illustrated in FIG. 5A, the plurality of layers 110L may include a first layer 110L1 to an n-th layer 110Ln which are spaced apart in the laminating direction. In this embodiment, the plurality of layers 110L may include a first layer 110L1 to a fourth layer 110L4.

The plurality of layers 110L may each be formed on a surface of each insulator 110I (e.g., prepreg).

The insulators 110I may include first to third insulators 110I1 to 11013 spaced apart along the laminating direction.

In some embodiments, the first layer 110L1 and the second layer 110L2 may be formed on lower surface and upper surface of the first insulator 110I1, respectively. The third layer 110L3 and the fourth layer 110L4 may be formed on lower surface and upper surface of the third insulator 11013, respectively. The second insulator 11012 may be inserted between the second layer 110L2 and the third layer 110L3. Accordingly, the second layer 110L2 and the third layer 110L3 may be insulated from each other.

As illustrated in FIG. 5B, the via holes (the n_n-1-th via hole 210a1 and the 2_1-th via hole 210a2) may be formed using the drill 200, through the n-th layer 110Ln, the third insulator 110I3, and the n-1-th layer 110Ln-1, and through the second layer 110L2, the first insulator 110I1, and the first layer 110L1, respectively.

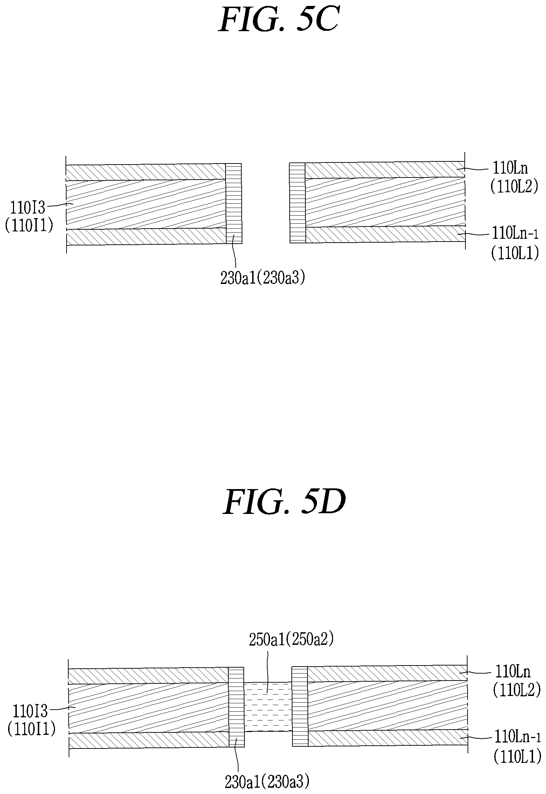

As illustrated in FIG. 5C, the inner plating layers 230a1 and 230a3 may be formed inside the respective via holes 210a (the n_n-1-th via hole 210a1 and the 2_1-th via hole 210a2). The n_n-1-th inner plating layer 230a1 may be formed inside the n_n-1-th via hole 210a1 by copper (Cu) plating. The 2_1-th inner plating layer 230a3 may be formed inside the 2_1-th via hole 210a2 by copper (Cu) plating.

In some embodiments, as illustrated in FIG. 5D, the filling parts 250a may be formed by filling the respective inner plating layers 230a1 and 230a3 with the insulating material (e.g., resin). The n_n-1-th filling part 250a1 may be formed inside the n_n-1-th inner plating layer 230a1. The 2_1-th filling part 250a2 may be formed inside the 2_1-th inner plating layer 230a3.

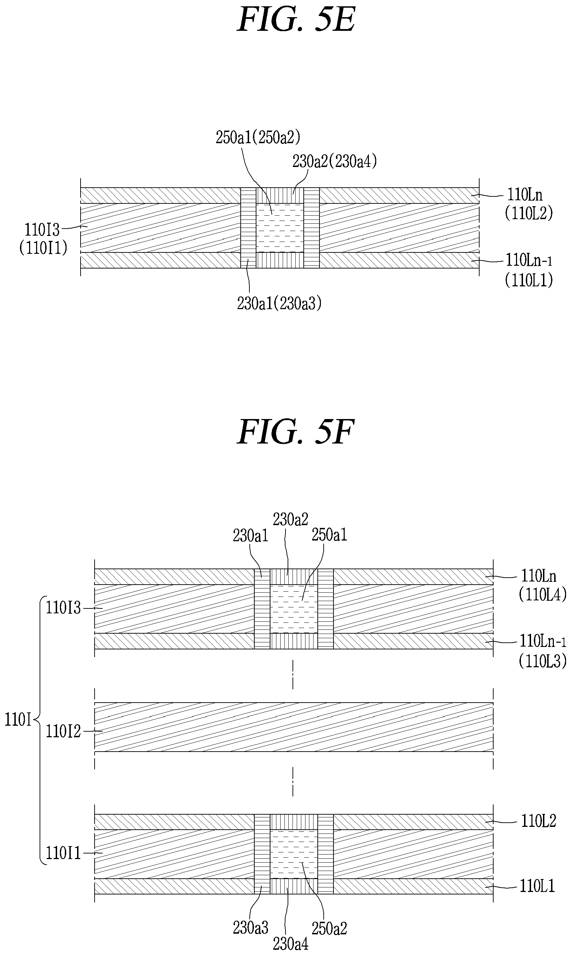

As illustrated in FIG. 5E, the end plating layers 230a2 and 230a4 may be formed on opposite ends of the respective via holes 210a (the n_n-1-th via hole 210a1 and the 2_1-th via hole 210a2) by copper (Cu) plating.

The n_n-1-th end plating layers 230a2 may be formed on the opposite ends of the n_n-1-th via hole 210a1.

The 2_1-th end plating layers 230a4 may be formed on the opposite ends of the 2_1-th via hole 210a2.

The plurality of layers 110L may be arranged in layers along the laminating direction, as illustrated in FIG. 5F, when the end plating layers 230a2 and 230a4 are formed on the opposite ends of the respective via holes.

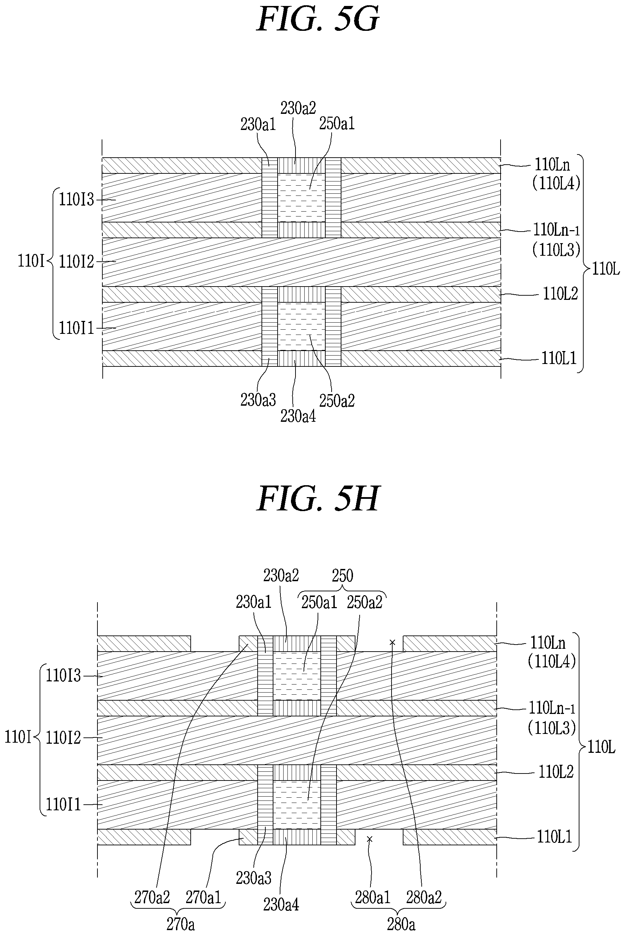

As illustrated in FIG. 5G, the plurality of layers 110L arranged in layers may be bonded together (e.g., hot-pressed).

When the plurality of layers 110L are bonded together, the pads 270a may be formed in a preset shape by cutting the end plate layers 230a2 and 230a4, which are exposed to the outside, of the plating layers 230a to be separated from the surrounding areas.

As illustrated in FIG. 5H, the periphery of the n_n-1-th end plating layer 230a2, which is exposed to the outside, of the n_n-1-th end plating layer 230a2 and the periphery of the 2_1-th end plating layer 230a4, which is exposed to the outside, of the 2_1-th end plating layer 230a4 may be cut to be separated from the surrounding areas, thereby forming the upper pad 270a2 and the lower pad 270a1, respectively.

The upper cut portion 280a2 may be formed around the upper pad 270a2 by removing a portion of the n-th layer 110Ln (the fourth layer 110L4).

The lower cut portion 280a1 may also be formed around the lower pad 270a1 by removing a portion of the first layer 110L1.

When each of the pads 270a is formed, an insulating layer 150 may be formed by coating an insulating material on outer surfaces of the first layer 110L1 and the n-th layer 110Ln.

The insulating layer 150 may include a lower insulating layer 1501 coated on the outer surface of the first layer 110L1, and an upper insulating layer 1502 coated on the outer surface of the n-th layer 110Ln.

The insulating material forming the insulating layer 150 may be, for example, a permanent ink.

After the insulating layer 150 is formed on each of the surface of the n-th layer 110Ln and the surface of the first layer 110L1, the component 300a may be mounted on the corresponding pad 270a by interposing the solder 290a between the component 300a and the pad 270a (see FIG. 4). In some embodiments, the lower component 300a1 may be mounted on the lower pad 270a1 by interposing the lower solder 290a1 between the lower component 300a1 and the lower pad 270a1, and the upper component 290a1 may be mounted on the upper pad 270a2 by interposing the upper solder 290a2 between the upper component 290a1 and the upper pad 270a2.

With the configuration, a signal input from the upper component 300a2 of the substrate 110 may be transmitted to the third layer 110L3 via the upper solder 290a2, the upper pad 270a2, and the inner plating layer 230a (the n_n-1-th inner plating layer 230a1).

Also, a signal input from the lower component 300a1 of the substrate 110 may be transmitted to the second layer 110L2 via the lower solder 290a1, the lower pad 270a1, and the inner plating layer 230a (the 2_1-th inner plating layer 230a3).

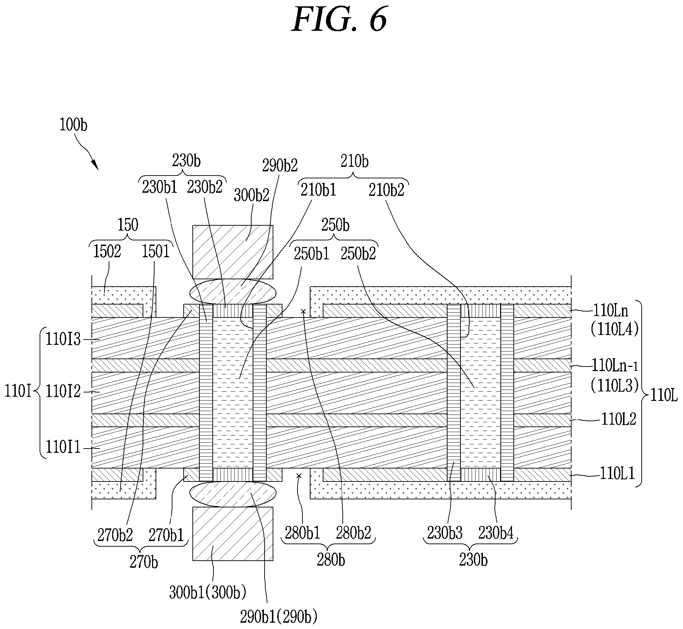

FIG. 6 is a cross-sectional view of a main part of a printed circuit board (PCB) according to still another embodiment.

As illustrated in FIG. 6, a PCB 100b according to still another embodiment may include a substrate 110, a via hole 210b, a plating layer 230b, and a pad 270b.

The substrate 110 may include a plurality of layers 110L that are laminated in layers.

In this embodiment, the plurality of layers 110L may be circuit layers made of, for example, a conductor (for example, copper (Cu)).

The plurality of layers 110L may include a first layer 110L1 to an n-th layer 110Ln along the laminating direction. This embodiment illustrates an example in which the plurality of layers 110L include a first layer 110L1 to a fourth layer 110L4, but may not be limited thereto.

A plate-shaped insulator 110I (for example, prepreg) may be provided between the plurality of layers 110L.

The insulator 110I may include, for example, first to third insulators 110I1 to 11013 spaced apart along a thickness direction.

The plurality of layers 110L may be arranged on one or opposite surfaces of the insulator 110I.

In some embodiments, the first layer 110L1 may be arranged on a lower surface of the first insulator 110I1.

The second layer 110L2 may be arranged on a lower surface of the second insulator 11012.

The third layer 110L3 may be arranged on a lower surface of the third insulator 110I3, and the fourth layer 110L4 may be arranged on an upper surface of the third insulator 11013.

An insulating layer 150 may be arranged on each of opposite surfaces of the substrate 110 along the laminating direction.

The insulating layer 150 may be formed by coating the surface of the first layer 110L1 and the surface of the n-th layer 110Ln with, for example, a permanent ink.

The insulating layer 150 may include a lower insulating layer 1501 coated on the surface of the first layer 110L1, and an upper insulating layer 1502 coated on the surface of the n-th layer 110Ln.

The substrate 110 may include a via hole 210b formed through at least two layers.

The via hole 210b may be formed by using a drill 220.

Accordingly, the use of expensive equipment may be eliminated when forming the via hole 210b, thereby suppressing a significant increase in manufacturing cost.

The via hole 210b, for example, may have a diameter of 0.6 mm.

In some embodiments, the via hole 210b may include, for example, a through-via hole 210b1 formed through the n-th layer 110Ln to the first layer 110L1.

The through-via hole 210b1 may be formed sequentially through the n-th layer 110Ln (the fourth layer 110L4), the third insulator 110I3, the third layer 110L3, the second insulator 11012, the second layer 110L2, the first insulator 110I1, and the first layer 110L1.

The via hole 210b may include an intermediate via hole 210b2 that is formed through two continuous layers among the first layer 110L1 to the n-th layer 110Ln, and is not exposed to the outside.

The intermediate via hole 210b2 may be formed, for example, sequentially through the n-th layer 110Ln (the fourth layer 110L4), the third insulator 110I3, the third layer 110L3, the second insulator 11012, the second layer 110L2, the first insulator 110I1, and the first layer 110L1.

This embodiment illustrates an example in which the intermediate via hole 210b2 is formed through the n-th layer 110Ln to the first layer 110L1, but is merely illustrative, and may not be limited thereto.

A plating layer 230b may be formed on the inside and outside of the via hole 210b. The plating layer 230b may be formed, for example, by copper (Cu) plating.

In some embodiments, an inner plating layer 230b1 may be formed on an inner surface of the through hole 210b1.

End plating layers 230b2 may be formed on opposite ends of the through-via hole 210b1 along the laminating direction.

An inner plating layer 230b3 may be formed on an inner surface of the through-via hole 210b2.

End plating layers 230b4 may be formed on opposite ends of the through-via hole 210b2 along the laminating direction.

In this embodiment, the end plating layers 230b4 on the opposite sides of the intermediate via hole 210b2 may be arranged inside the insulating layer 150 and therefore may not be exposed to the outside.

Here, the end plating layers 230b2 on the opposite sides of the through-via hole 210b1 may be exposed to the outside.

A filling part 250b may be formed by filling the plating layer 230b with an insulating material.

The filling part 250b may include a first filling part 250b1 formed inside the through-via hole 210b1, and a second filling part 250b2 formed inside the intermediate via hole 210b2.

In some embodiments, the end plating layers 230b2 on the opposite sides of the through-via hole 210b1 may be cut to be separated from surrounding areas (the n-th layer 110Ln and the first layer 110L1), thereby forming pads 270b, respectively. The pads 270b formed on the opposite sides of the through-via hole 210b1 may include a lower pad 270b1 formed on a lower side of the substrate 110 and an upper pad 270b2 formed on an upper side of the substrate 110.

The pad 270b may be formed to have a larger size than the via hole 210b.

Accordingly, a portion of a conductor on the periphery of the corresponding inner plating layer 230a1, 230a3 may form the pad 270b.

A cut portion 280b may be formed by cutting an area of the periphery of the corresponding pad 270b. In some embodiments, a lower cut portion 280b1 may be formed on the periphery of the lower pad 270b1, and an upper cut portion 280b2 may be formed on the periphery of the upper pad 270b2.

Components 300b may be mounted on the respective pads 270b1 and 270b2 on the opposite sides of the through-via hole 210b1 by interposing solders 290b between the components 300b and the pads 270b1 and 270b2, respectively.

In some embodiments, a lower component 300b2 may be mounted on the lower pad 270b1 by interposing a lower solder 290b1 between the lower component 300a1 and the lower pad 270a1, and an upper component 290a1 may be mounted on the upper pad 270b2 by interposing an upper solder 290b2 between the upper component 290a1 and the upper pad 270a2.

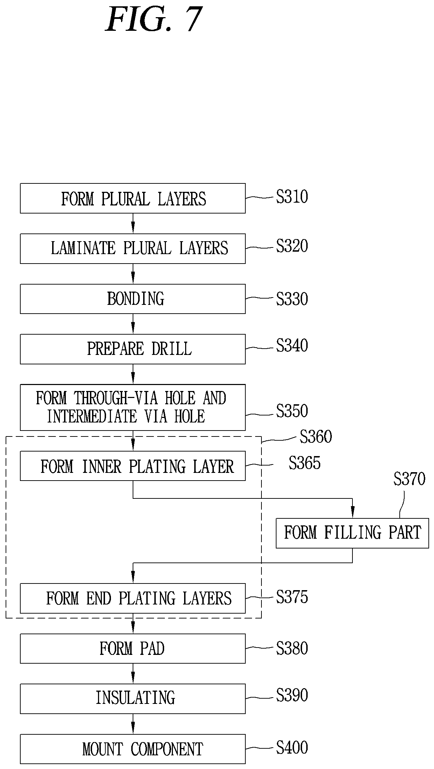

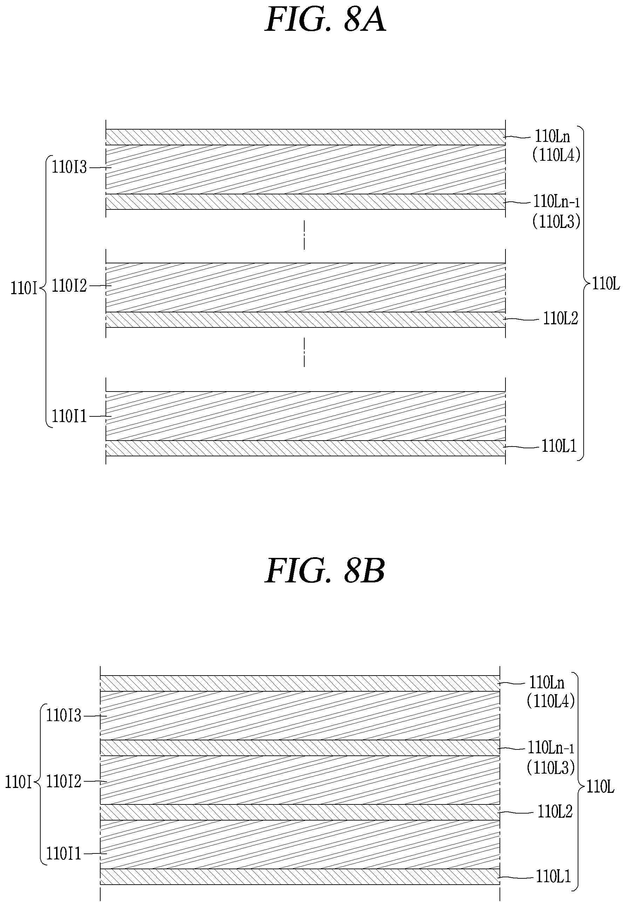

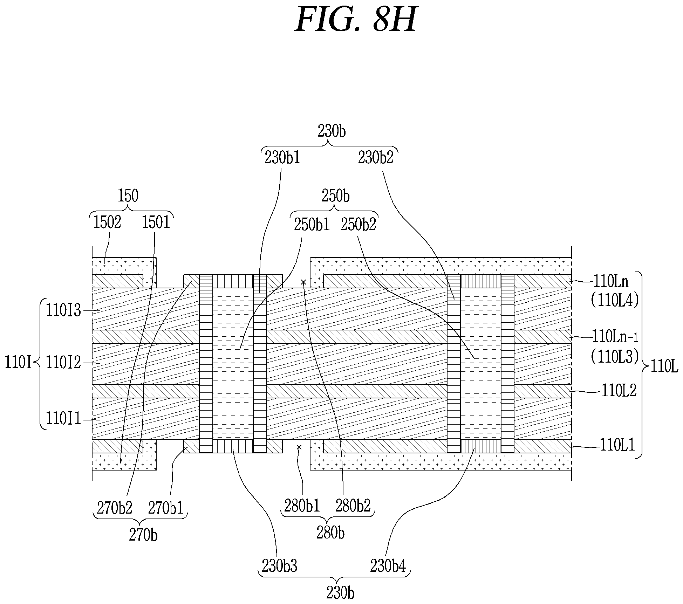

FIG. 7 is a view for explaining a method of manufacturing a PCB according to another embodiment, and FIGS. 8A to 8H are views for explaining a manufacturing process of the PCB of FIG. 6.

As illustrated in FIG. 7, a method for manufacturing a printed circuit board 100b according to an embodiment of the disclosure may include: forming a first layer 110L1 to an n-th layer 110Ln which are arranged in layers with insulators 110I therebetween (S310); stacking the first layer 110L1 to the n-th layer 110Ln such that the first layer 110L1 is arranged on the lowermost side and the n-th layer 110Ln is arranged on the uppermost side along a laminating direction (S320); forming a via hole 210b including a through-via hole 210b1 formed through the n-th layer 110Ln to the first layer 110L1 (S350); forming a plating layer 230b inside and outside the via hole 210b including the through-via hole 210b1 (S360); and forming a pad 270b by separating the plating layer 230b, which is exposed to the outside, of the plating layer 230b of the through-via hole 210b1 from a surrounding area (S380).

As illustrated in FIG. 8A, the plurality of layers 110L of the substrate 110 may include a first layer 110L1 to an n-th layer 110Ln which are spaced apart in the laminating direction. This embodiment illustrates an example in which the plurality of first layer 110L1 to the n_th layer 110Ln are implemented as the first layer 110L1 to the fourth layer 110L4, but may not be limited thereto.

The first layer 110L1 to the n-th layer 110Ln may be spaced apart along the laminating direction, and an insulator 110I may be arranged between adjacent layers of the first layer 110L1 to the n-th layer 110Ln. Accordingly, the plurality of first layers 110L1 to n-th layers 110Ln may be insulated from one another.

The plurality of first layer 110L1 to n-th layer 110Ln may be circuit layers formed of a conductor (e.g., copper (Cu)).

The insulator 110I may be implemented, for example, prepreg.

The insulator 110I may include a first insulator 110I1 to a third insulator 110I3 implemented in the form of a plate.

In this embodiment, the first layer 110L1 may be arranged on a lower surface of the first insulator 110I1, and the second layer 110L2 may be arranged on a lower surface of the second insulator 11012. The third layer 110L3 may be arranged on a lower surface of the third insulator 11013, and the fourth layer 110L4 may be arranged on an upper surface of the third insulator 11013.

The manufacturing method may further include, after stacking the plurality of layers (S320), bonding the plurality of layers 110L (S330).

The plurality of first layer 110L1 to n-th layer 110Ln may be stacked and bonded, as illustrated in FIG. 8B. Here, the plurality of first layer 110L1 to n-th layer 110Ln may be bonded together by being pressed in a high-temperature vacuum state, for example.

A via hole 210b may be formed in the bonded substrate 110.

The manufacturing method may further include, prior to forming the via hole 210b (S350), preparing a drill 220 (S340).

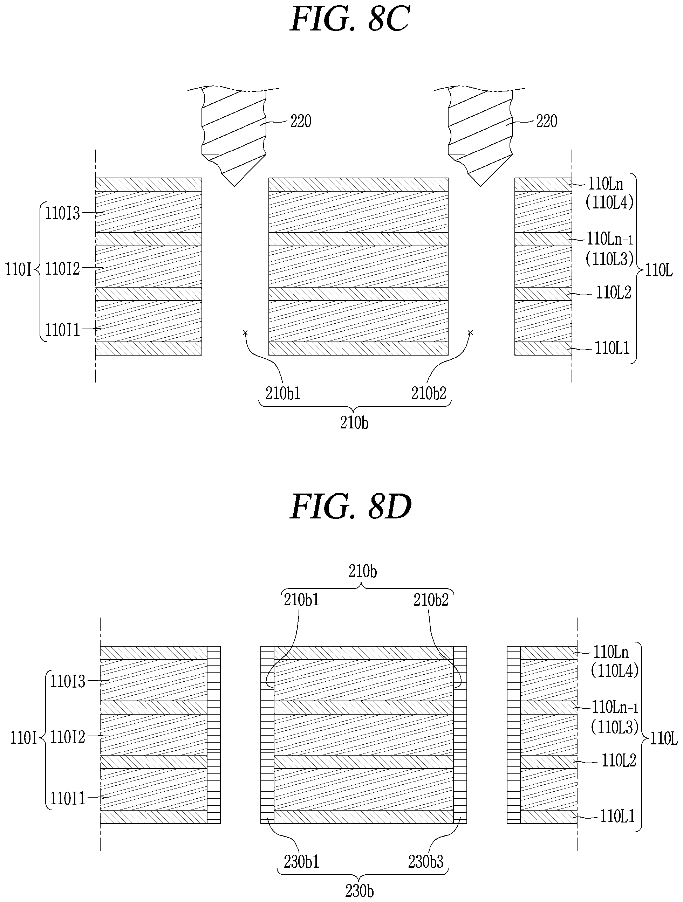

The via hole 210b may be formed by the drill 220, as illustrated in FIG. 8C, in the bonded substrate 110.

The via hole 210b may include, for example, a through-via hole 210b1 formed sequentially through the n-th layer 110Ln to the first layer 110L1.

An intermediate via hole 210b2 may be formed on one side of the through-via hole 210b1. The intermediate via hole 210b1 may be formed through two continuous layers of the first layer 110L1 to the n-th layer 110Ln, and may not be exposed to the outside.

This embodiment illustrates an example in which the intermediate via hole 210b2 penetrates from the n-th layer 110Ln to the first layer 110L1, but is merely illustrative, and may not be limited thereto.

The plating layer 230b may be formed inside and outside the via hole 210b (the through-via hole 210b1 and the intermediate via hole 210b2) by copper (Cu) plating.

The step (S360) of forming the plating layer 230b inside and outside the via hole 210b including the through-via hole 210b1 may include forming an inner plating layer 230b on an inner surface of the via hole 210b (S365), and forming end plating layers 230b on opposite ends of the via hole 210b (S375).

In this embodiment, the step (S365) of forming the inner plating layer 230b may include forming the inner plating layer 230b on the inner surface of the through-via hole 210b1, and forming the inner plating layer 230b on the inner surface of the intermediate via hole 210b2.

The step (S375) of forming the end plating layers 230b on the opposite sides of the via hole 210b may include forming the end plating layers 230b on opposite ends of the through-via hole 210b1, and forming the end plating layers 230b on opposite ends of the intermediate via hole 210b2.

As illustrated in FIG. 8D, the inner plating layers 230b may be formed on the inner surfaces of the through-via hole 210b1 and the intermediate via hole 210b2 by copper (Cu) plating.

In some embodiments, the manufacturing method may further include, prior to forming the end plating layers 230b of the via hole 210b (S375), forming a filling part 250b by filling the via hole 210b with an insulating material (resin) (S370).

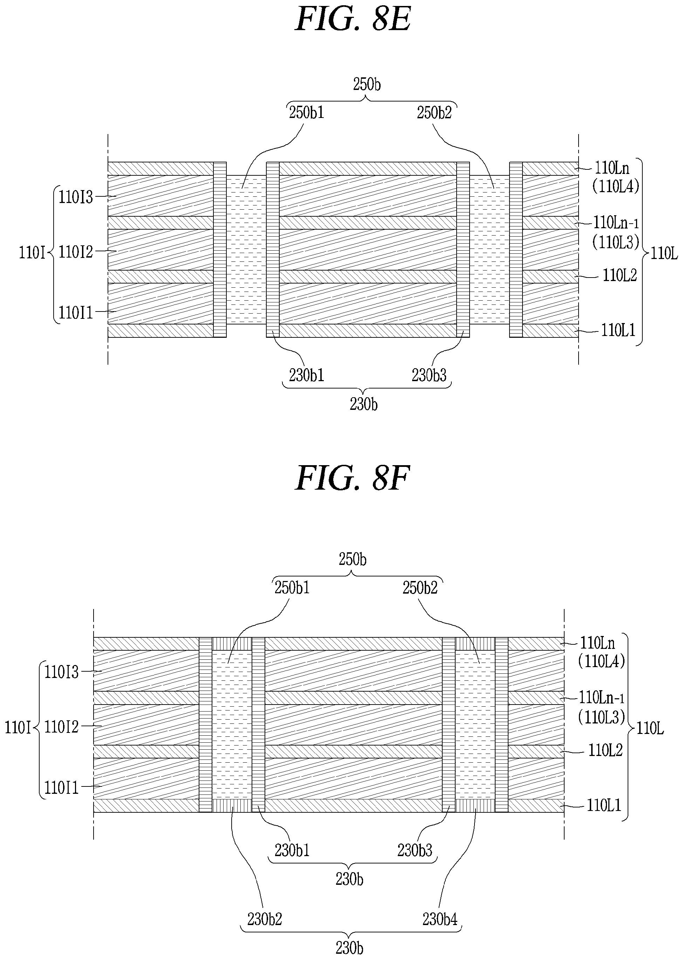

As illustrated in FIG. 8E, the filling parts 250b may be formed by filling the through-via hole 210b1 and the intermediate via hole 210b2, respectively, with the insulating material (resin).

The filling part 250b may include a first filling part 250a1 filled inside the through-via hole 210b1, and a second filling part 250a2 filled inside the intermediate via hole 210b2.

As illustrated in FIG. 8F, the end plating layers 230b2 may be formed on the opposite sides of the through-via hole 210b1 and the opposite sides of the intermediate via hole 210b2, respectively, by copper (Cu) plating.

Accordingly, the n-th layer 110Ln (the fourth layer 110L4), the n-1-th layer 110Ln-1 (the third layer 110L3), the second layer 110L2, and the first layer 110L1 may be electrically connected.

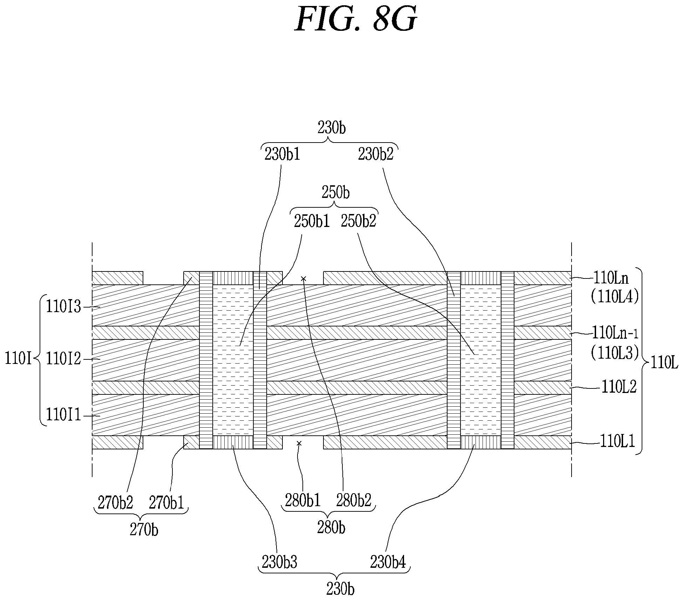

In some embodiments, as illustrated in FIG. 8G, the end plating layers 230b2 on the opposite sides of the through-via hole 210b1 in the laminating direction of the substrate 110 may be cut off to be separated from surrounding areas, thereby forming the pad 270b.

In this embodiment, the pad 270b may be configured to be separated from the n-th layer 110Ln and the first layer 110L1. The cut portion 280b may be formed on the periphery of the pad 270b by cutting off each of the n-th layer 110Ln and the first layer 110L1.

The pad 270b may have a size larger than a diameter of the through-via hole 210b1, for example.

The pad 270b may include an upper pad 270b2 arranged on an upper side and a lower pad 270b1 arranged on a lower side of the substrate 110 in the thickness direction of the substrate 110 (up-down (vertical) direction in the drawing).

The upper pad 270b2 may include, for example, a portion of the n-th layer 110Ln (the fourth layer 110L4).

An upper cut portion 280b2 may be formed on the periphery of the upper pad 270b2 by removing a portion of the n-th layer 110Ln (the fourth layer 110L4).

The lower pad 270b1 may include, for example, a portion of the first layer 110L1.

A lower cut portion 280b1 may be formed on the periphery of the lower pad 270b1 by cutting (removing) a portion of the first layer 110L1.

In some embodiments, the manufacturing method may further include, after the step (S380) of forming the pad 270b by separating the plating layer 230b, which is exposed to the outside, of the plating layer 230b of the through-via hole 210b1 from the peripheral area, insulating opposite surfaces of the substrate 110 in the thickness direction of the substrate 110 to form an insulating layer 150 (S390).

The insulating layer 150 may be formed by coating the opposite surfaces (lower surface and upper surface) of the substrate 110 in the thickness direction with a permanent ink. The insulating layer 150 may include a lower insulating layer 1501 coated on the outer surface of the first layer 110L1, and an upper insulating layer 1502 coated on the outer surface of the n-th layer 110Ln.

The upper pad 270b2 and the lower pad 270b1 may be exposed to the outside.

The end plating layers 230b4 on the opposite sides of the intermediate via hole 210b2 may not be exposed to the outside because the opposite ends thereof are coated with the coating layer 150.

The manufacturing method may further include, after the step (S390) of insulating the opposite surfaces of the substrate 110 in the thickness direction to form the insulating layer 150, mounting a component on the pad 270a by interposing a solder 290a between the component and the pad 270a (S400).

A lower component 300a1 may be mounted on the lower pad 270a1 by interposing a lower solder 290a1 between the lower component 300a1 and the lower pad 270a1, and an upper component 300a2 may be mounted on the upper pad 270a2 by interposing an upper solder 290a2 between the upper component 300a2 and the upper pad 270a2.

With the configuration, a signal input from the upper component 300b2 of the substrate 110 may be input to the inner plating layer 230b1 via the upper solder 290b2 and the upper pad 270b2. Also, a signal input from the lower component 300b2 may be input to the inner plating layer 230b1 via the lower solder 290b1 and the lower pad 270b1.

The signal input to the inner plating layer 230b1 of the through-via hole 210b1 may be transmitted to the third layer 110L3 and/or the second layer 110L2.

The foregoing description has been given of specific embodiments of the present disclosure. However, since the present disclosure can be embodied in various forms without departing from the essential characteristics, the implementations described above should not be limited by the specific contents for carrying out the invention.

In addition, even implementations not listed in the detailed description should be interpreted within the scope of the technical idea defined in the appended claims. It is intended that the present disclosure cover the modifications and variations of this invention provided they come within the scope of the appended claims and their equivalents.

## Claims

1. A printed circuit board comprising:
a substrate comprising a first layer to an n-th layer laminated in layers;
a via hole formed in a penetrating manner, including the first layer or the n-th layer, in a laminating direction;
a plating layer formed inside and outside the via hole; and
a pad formed by separating a plating layer formed on an end of the via hole from a peripheral area.

2. The printed circuit board of claim 1, wherein the via hole comprises an n_n-1-th via hole formed through the n-th layer and an n-1-th layer,
the plating layer comprises: an n_n-1-th inner plating layer formed on an inner surface of the n_n-1-th via hole; and n_n-1-th end plating layers formed on opposite ends of the n_n-1-th via hole, respectively, and
the pad is formed on the n_n-1-th end plating layers, exposed to outside, of the n_n-1-th end plating layers of the n_n-1-th via hole.

3. The printed circuit board of claim 2, further comprising: an n_n-1-th filling part formed by filling an inside formed by the n_n-1-th inner plating layer and the n_n-1-th end plating layers of the n_n-1-th via hole with an insulating material.

4. The printed circuit board of claim 1, wherein the via hole comprises a 2_1-th via hole formed through a second layer and the first layer,
the plating layer comprises: a 2_1-th inner plating layer formed on an inner surface of the 2_1-th via hole, and 2_1-th end plating layers formed on opposite ends of the 2_1-th via hole, respectively, and
the pad is formed on the 2_1-th end plating layers, exposed to outside, of the 2_1-th end plating layers of the 2_1-th via hole.

5. The printed circuit board of claim 4, further comprising: a 2_1-th filling part formed by filling an inside formed by the 2_1-th inner plating layer and the 2_1-th end plating layers of the 2_1-th via hole with an insulating material.

6. The printed circuit board of claim 1, wherein the via hole comprises a 2_1-th via hole formed through a second layer and the first layer, and an n_n-1-th via hole formed through the n-th layer and an n-1-th layer,
the plating layer comprises: a 2_1-th inner plating layer formed on an inner surface of the 2_1-th via hole; 2_1-th end plating layers formed on opposite ends of the 2_1-th via hole, respectively; an n_n-1 inner plating layer formed on an inner surface of the n_n-1-th via hole; and n_n-1-th end plating layers formed on opposite ends of the n_n-1-th via hole, respectively, and
the pad is formed on the 2_1-th end plating layers, exposed to outside, of the 2_1-th end plating layers of the 2_1-th via hole, and the n_n-1-th end plating layers, exposed to outside, of the n_n-1-th end plating layers of the n_n-1-th via hole.

7. The printed circuit board of claim 6, further comprising:
a 2_1-th filling part formed by filling an inside formed by the 2_1-th inner plating layer and the 2_1-th end plating layers of the 2_1-th via hole with an insulating material; and
an n_n-1-th filling part formed by filling an inside formed by the n_n-1-th inner plating layer and the n_n-1-th end plating layers of the n_n-1-th via hole with an insulating material.

8. The printed circuit board of claim 1, wherein the via hole comprises a through-via hole formed through the first layer to the n-th layer,
the plating layer comprises an inner plating layer formed on an inner surface of the through-via hole and end plating layers formed on opposite ends of the through-via hole, respectively, and
the pad is formed on the end plating layers formed on the respective opposite ends of the through-via hole.

9. The printed circuit board of claim 8, further comprising a filling part formed by filling an inside formed by the inner plating layer and the end plating layers of the through-via hole with an insulating material.

10. The printed circuit board of any of claims 1 to 9, wherein insulators formed in a shape of plate are arranged between adjacent layers of the first layer to the n-th layer, and
the via hole is formed by a drill.

11. The printed circuit board of claim 10, the via hole further comprises an intermediate via hole formed through at least two continuous layers of the first layer to the n-th layer, not to be exposed to the outside,
the plating layer comprises an inner plating layer formed on an inner surface of the intermediate via hole and end plating layers formed on opposite ends of the intermediate via hole, respectively, and
the printed circuit board further comprises a filling part formed by filling an inside formed by the inner plating layer and the end plating layers of the intermediate via hole with an insulating material.

12. A method for manufacturing a printed circuit board, the method comprising:
forming a plurality of layers arranged in layers with insulators therebetween;
forming a via hole in a penetrating manner, including an n-th layer arranged on an uppermost side or a first layer arranged on a lowermost side in a laminating direction;
forming a plating layer inside and outside the via hole; and
forming a pad by separating a plating layer, exposed to outside, of the plating layer of the via hole from a peripheral area.

13. The method of claim 12, wherein the forming the plating layer comprises:
forming an inner plating layer on an inner surface of the via hole; and
forming end plating layers formed on opposite ends of the via hole, respectively.

14. The method of claim 13, further comprising, prior to forming the end playing layers,
forming a filling part by filling an inside of the inner plating layer with an insulating material.

15. The method of claim 12, further comprising, prior to forming the via hole:
preparing a drill to drill through the plurality of layers.

16. The method of claim 12, wherein the forming the via hole comprises:
forming a 2_1-th via hole through a second layer and the first layer.

17. The method of claim 12, wherein the forming the via hole comprises:
forming an n_n-1-th via hole through the n-th layer and an n-1-th layer.

18. The method of any of claims 12 to 17, further comprising, prior to forming the pad:
laminating the plurality of layers in layers; and
insulating surfaces of the plurality of layers laminated in layers.

19. A method for manufacturing a printed circuit board, the method comprising:
forming a first layer to an n-th layer, arranged in layers with insulators therebetween;
laminating the first layer to the n-th layer such that the first layer is arranged on a lowermost side and the n-th layer is arranged on an uppermost side in a laminating direction;
forming a via hole comprising a through-via hole penetrating from the n-th layer to the first layer;
forming a plating layer inside and outside the via hole comprising the through-via hole; and
forming a pad by separating a plating layer, exposed to outside, of the plating layer of the through-via hole from a peripheral area.

20. The method of claim 19, wherein the forming the via hole comprises:
forming an intermediate via hole through at least two continuous layers of the first layer to the n-th layer, not to be exposed to the outside.
